# EUROPEAN PATENT APPLICATION

(11) **EP 4 765 207 A1**
(43) Date of publication of application: **24.06.2026**
(21) Application number: 25771641.5
(22) Date of filing: 27.01.2025
(51) Int. Cl.: H01L 25/07

(54) **SEMICONDUCTOR DEVICE**

(30) Priority: 15.03.2024 JP 2024041118
(71) Applicant: Fuji Electric Co., Ltd., Kawasaki-shi, Kanagawa 210-9530 (JP)
(72) Inventor: SAITO, Takashi, Kawasaki-shi, Kanagawa 210-9530 (JP)
(74) Representative: Appelt, Christian W.
(86) International application number: PCT/JP2025/002371
(87) International publication number: WO 2025/192058

(57) **Abstract**

There is provided a semiconductor device in which excessive wet-spreading of solder is suppressed. The semiconductor device includes an insulating circuit board (1) having an insulating substrate (11) and an upper conductor layer (12a) and an upper conductor layer (12b) provided separately from each other on an upper surface of the insulating substrate (11), a semiconductor chip (3) mounted on the upper conductor layer (12a) via solder, an external terminal (4) having a joining part (41), the joining part (41) being joined to a first joining region (14) via solder (2b), the first joining region (14) being one region of an upper surface of the upper conductor layer (12b), a printed circuit board (6) arranged above the semiconductor chip (3), a pin terminal (51) inserted into the printed circuit board (6) and joined to a second joining region (15) via solder (9a), the second joining region (15) being another one region of the upper surface of the upper conductor layer (12b), and a solder resist (7) provided on an upper surface side of the upper conductor layer (12b) and adjacent to the first joining region (14).

## Description

### Technical Field

The present invention relates to a semiconductor device (semiconductor module) mounted with a power semiconductor chip.

### Background Art

A semiconductor device mounted with a power semiconductor chip (hereinafter simply referred to as "semiconductor chip") is mainly utilized for variable speed drives, such as motors and inverters, and for power conversion. To a substrate of the semiconductor device, members constituting wiring are joined in addition to the semiconductor chip. By irradiating the upper surface of a metal layer arranged on such a substrate with laser light, a resist is formed in some cases.

PTL 1 describes a technology in which one end of an external terminal is joined to the upper surface of an upper conductive layer via a joining material, such as solder. Further, a technology is described in which a semiconductor chip is arranged in the center of a semiconductor device and the external terminal is arranged on the peripheral side of the semiconductor device.

PTL 2 describes a power semiconductor device including a lower substrate on which a power semiconductor element is mounted, an upper substrate arranged facing the lower substrate, a plate-shaped connecting member electrically connecting an element electrode formed on the power semiconductor element and a circuit pattern formed on the upper substrate to each other, and a control terminal.

PTL 3 describes metal plates, wire, die pads, pads, and the like.

PTL 4 describes a technology in which a gate connection terminal and an emitter signal terminal are fixed to a circuit pattern of a printed circuit board and an end part is also fixed to a first copper plate on an insulating board.

PTL 5 describes a technology in which a low-wettability part having low wettability to solder is formed on an electrode pad of a semiconductor chip, and a solder paste containing flux is printed to cover a top part of the low-wettability part, in which the solder paste is reflowed to form a solder bump conductive with the electrode pad and gas generated from the flux comes into contact with and remains on the top part of the low-wettability part to form a void in the solder bump.

PTL 6 describes a technology in which a nickel (Ni) plating layer is formed on the surface of a circuit layer of a semiconductor device circuit board, and a part to be subjected to solder joining to which a semiconductor element is soldered and an altered part due to laser irradiation are arranged adjacent to each other in a plane direction on the formed nickel plating layer.

PTL 7 describes a technology in which a substrate is joined to one main surface of a heat sink by a solder layer, a semiconductor element is joined onto one main surface of the substrate by a solder layer, a case is bonded to the one main surface of the heat sink to surround the substrate, the case includes an internal electrode electrically connected to the semiconductor element on the inner peripheral side, a bonding surface with the case in the one main surface of the heat sink has a first region where a resist layer is formed and a second region where the resist layer is not formed, and the second region is formed to contain a region overlapping in plan view the internal electrode.

In PTL 8, a cell unit is formed by soldering a semiconductor chip to one surface of an insulating circuit board having a conductive pattern on each surface, and an insulating inorganic layer is formed by being bonded by a metal mask to a portion where the cell unit is not soldered of a metal base dissipating heat generated in the semiconductor chip. A technology is described in which the cell unit is soldered to the metal base, followed by sealing with an insulating resin.

PTL 9 describes providing a liquid-repellent part formed by laser irradiation to a circuit board of a ceramic circuit board. PTL 1 also describes a technology in which the liquid-repellent part is provided between regions where a semiconductor chip and a contact component are individually arranged.

### Citation List

### Patent Literatures

PTL 1: JP7409035B2
PTL 2: JP2015-142018A
PTL 3: JP2021-068783A
PTL 4: JP5644440B2
PTL 5: JP2015-076429A
PTL 6: JP2014-167983A
PTL 7: JP2019-197831A
PTL 8: JP2008-172066A
PTL 9: JP2021-118350A

### Summary of Invention

### Technical Problem

When wiring is constituted using a pin terminal in place of wire, a part of the pin terminal is joined to a metal layer of a substrate via a joining material, such as solder. The solder melted in reflow sometimes wet-spreads.

In view of the above-described problem, it is an object of the present invention to provide a semiconductor device in which excessive wet-spreading of solder is suppressed.

### Solution to Problem

One aspect of the present invention is a semiconductor device including: (a) an insulating circuit board having an insulating substrate and a first conductor layer and a second conductor layer provided separately from each other on an upper surface of the insulating substrate; (b) a semiconductor chip mounted on the first conductor layer via solder; (c) an external terminal having a joining part, the joining part being joined to a first joining region via solder, the first joining region being one region of an upper surface of the second conductor layer; (d) a printed circuit board arranged above the semiconductor chip; (e) a first pin terminal inserted into the printed circuit board and joined to a second joining region via solder, the second joining region being another one region of the upper surface of the second conductor layer; and (f) a solder resist provided on an upper surface side of the second conductor layer and adjacent to the first joining region.

The second conductor layer is provided in proximity to a first side, the first side being one side of the insulating substrate, and when a side closer to the first side among the sides of the second conductor layer is set as a second side and a side opposite to the second side among the sides is set as a third side, the first joining region may be the region closer to the second side and the second joining region may be the region closer to the third side.

The solder resist may be provided between the first joining region and the second joining region.

The solder resist may be provided between the first joining region and the second side.

The external terminal may be separated from the printed circuit board.

The joining part may be provided with a boss protruding toward the second conductor layer.

The solder interposed between the joining part and the second conductor layer may have a thickness of 50 µm or more and 500 µm or less in a portion where the boss is not provided of the joining part.

The insulating substrate may contain a resin material.

Copper may be exposed to the surfaces of the first conductor layer and the second conductor layer.

The solder resist may be a laser resist provided by irradiating the upper surface of the second conductor layer with laser light.

The summary of the invention described above does not list all of the necessary features of the present invention. Further, subcombinations of these features can also be inventions.

### Advantageous Effects of Invention

The present invention can provide a semiconductor device in which excessive wet-spreading of solder is suppressed.

### Brief Description of Drawings

FIG. 1 is a cross-sectional view illustrating a vertical cross-sectional configuration of a part of a semiconductor device according to a first embodiment;
FIG. 2 is a plan view illustrating a part of an insulating circuit board possessed by the semiconductor device according to the first embodiment;
FIG. 3 is a plan view illustrating the positional relation among a first joining region, a second joining region, and a solder resist on an upper conductor layer according to the first embodiment;
FIG. 4 is a cross-sectional view illustrating a vertical cross-sectional configuration of a part of a semiconductor device according to a comparative example;
FIG. 5 is a plan view illustrating the positional relation among a first joining region, a second joining region, and a solder resist on an upper conductor layer according to a first modification of the first embodiment; and
FIG. 6 is a plan view illustrating the positional relation among a first joining region, a second joining region, and a solder resist on an upper conductor layer according to a second modification of the first embodiment.

### Description of Embodiments

Hereinafter, a first embodiment and modifications thereof are described with reference to the drawings. In the description of the drawings, the same or similar reference numerals are attached to the same or similar parts, and redundant descriptions are omitted. The drawings are schematic, and the relation between the thickness and the plane dimension, the thickness ratio of each layer, and the like are different from the actual relation, ratio, and the like in some cases. The drawings may also include portions different in mutual dimensional relations and ratios. The first embodiment and the modifications thereof described below exemplify devices or methods for embodying the technical idea of the present invention. The technical idea of the present invention does not specify the materials, shapes, structures, arrangement, and the like of constituent components to the materials, shapes, structures, arrangement, and the like described below.

The definitions of directions, such as upper and lower, in the following description are merely definitions for convenience of description and do not limit the technical idea of the present invention. It is a matter of course that, when an object is rotated 90° and observed, the upper and the lower are converted to the right and the left in reading, and when the object is rotated 180° and observed, the upper and the lower are reversed in reading, for example.

### (First embodiment)

### <Configuration of semiconductor device>

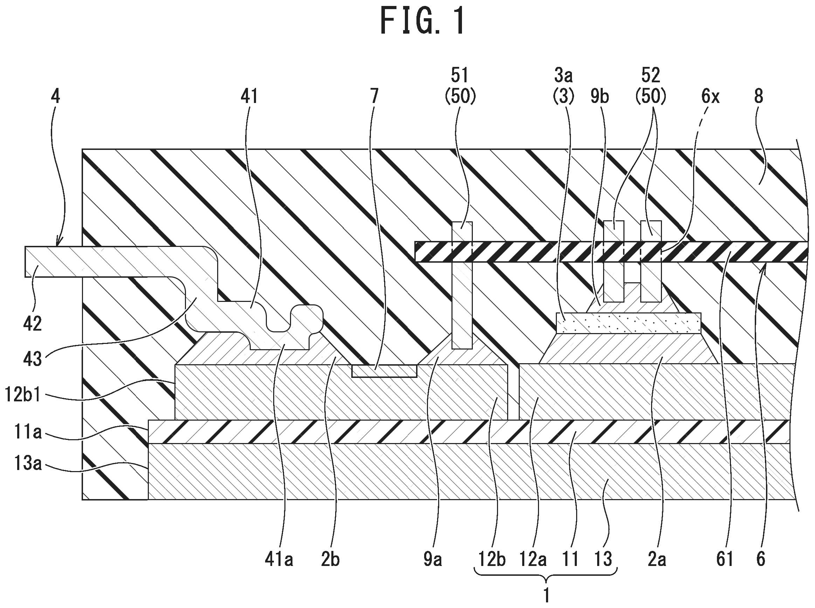

A semiconductor device according to the first embodiment includes an insulating circuit board 1, a semiconductor chip (semiconductor element) 3a mounted on the insulating circuit board 1 via solder 2a, an external terminal 4 connected onto the insulating circuit board 1 via solder 2b, and a printed circuit board 6 arranged above the semiconductor chip 3a at a distance from the semiconductor chip 3a as illustrated in FIG. 1. The surroundings of the semiconductor chip 3a and the printed circuit board 6 are sealed to be electrically insulated from the surroundings by a sealing member 8.

### <Insulating circuit board>

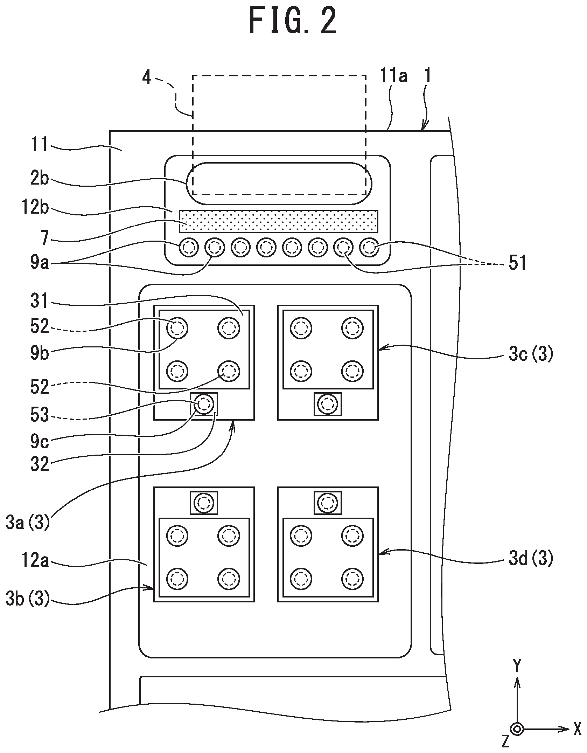

The insulating circuit board 1 includes an insulating substrate 11, upper conductor layers 12a, 12b arranged on the upper surface of the insulating substrate 11, which is the circuit surface side, and a lower conductor layer 13 arranged on the lower surface of the insulating substrate 11, which is the cooling surface side. As illustrated in FIG. 2, the upper conductor layers 12a, 12b are provided separately from each other and are not electrically conductive with each other. The upper conductor layer 12a is one example of the first conductor layer. The upper conductor layer 12b is one example of the second conductor layer. On the upper surface of the insulating substrate 11, an upper conductor layer other than the upper conductor layers 12a, 12b may be provided. The number of the upper conductor layers separated from each other may be three or more.

The insulating circuit board 1 may be a direct copper bonded (DCB) substrate or an active metal brazing (AMB) substrate, for example. The insulating substrate 11 is constituted by a ceramic substrate containing aluminum oxide (Al₂O₃), aluminum nitride (AlN), silicon nitride (Si₃N₄), or the like or a resin insulating substrate using a resin material, such as a polymer material, for example. The resin insulating substrate may contain a ceramic filler, such as boron nitride. This embodiment gives description supposing that the insulating substrate 11 is constituted by the resin insulating substrate. The upper conductor layers 12a, 12b and the lower conductor layer 13 are constituted by conductor foil or a conductive plate containing copper (Cu), aluminum (Al), or the like, for example. To the surfaces (upper surfaces) of the upper conductor layers 12a, 12b, metal (e.g., copper or aluminum) constituting the upper conductor layers 12a, 12b may be exposed as it is, or a nickel (Ni) plating layer may be formed on the surfaces. The upper conductor layers 12a, 12b form a predetermined circuit pattern. As illustrated in FIGS. 1 and 2, a solder resist 7 is provided on the upper surface side of the upper conductor layer 12b. The solder resist 7 is a laser resist.

As illustrated in FIG. 1, the semiconductor chip 3a is joined onto the upper conductor layer 12a via the solder 2a. An external terminal 4 is joined onto the upper conductor layer 12b via the solder 2b. For example, the semiconductor chip 3a is mounted only on the upper conductor layer 12a of the upper conductor layer 12a and the upper conductor layer 12b. The solder 2a, 2b is a joining material. As the solder, a tin-antimony (SnSb)-based solder or a tin-silver (SnAg)-based solder can be used, for example.

The type of the semiconductor chip 3a varies depending on the application. For example, power semiconductor elements, such as an insulating gate bipolar transistor (IGBT), a reverse conducting IGBT (RC-IGBT), a field effect transistor (FET), a static induction (SI) thyristor, and a gate turn-off (GTO) thyristor, and rectifiers, such as a freewheeling diode (FWD), can be adopted. The semiconductor chips 3a, 3b, 3c may be constituted by a silicon (Si) substrate or may be constituted by a compound semiconductor substrate containing a wide bandgap semiconductor, such as silicon carbide (SiC), gallium nitride (GaN), or gallium oxide (Ga₂O₃), for example. The semiconductor chip 3a is a power semiconductor chip, for example.

Although FIG. 1 illustrates one semiconductor chip 3a mounted on the upper conductor layer 12a, the number of the semiconductor chips is not particularly limited. For example, as illustrated in FIG. 2, four semiconductor chips 3a, 3b, 3c, 3d may be provided on the upper conductor layer 12a, or five or more semiconductor chips may be provided thereon. The semiconductor chip may be provided on an upper conductor layer other than the upper conductor layer 12b. When the semiconductor chips 3a, 3b, 3c, 3d are not distinguished from one another, the semiconductor chips 3a, 3b, 3c, 3d are sometimes simply referred to as semiconductor chip 3.

For example, when the semiconductor chip 3 is field effect transistor, the semiconductor chip 3 has a control electrode (gate electrode) and a first main electrode (source electrode) on the upper surface side and have a second main electrode (drain electrode) on the lower surface side. When the semiconductor chip 3 is IGBT or RC-IGBT, the semiconductor chip 3 has a control electrode (gate electrode) and a first main electrode (emitter electrode) on the upper surface side and have a second main electrode (collector electrode) on the lower surface side. When the semiconductor chip 3 is static induction thyristor, gate turn-off thyristor, or freewheeling diode, the semiconductor chip 3 has a first main electrode (e.g., anode electrode) on the upper surface side and have a second electrode (e.g., cathode electrode) on the lower surface side. Of the first main electrode and the second main electrode, the first main electrode is the main electrode to be joined to a pin terminal described later via solder. This embodiment gives description supposing that the semiconductor chip 3 is field effect transistor. As illustrated in FIG. 2, the semiconductor chip 3 has a source electrode 31 and a gate electrode 32 on the upper surface.

As illustrated in FIG. 1, the printed circuit board 6 is arranged above the semiconductor chip 3. The printed circuit board 6 includes an insulating layer 61, an upper wiring layer (not illustrated) arranged on the upper surface of the insulating layer 61, and a lower wiring layer (not illustrated) arranged on the lower surface of the insulating layer 61. The upper wiring layer and the lower wiring layer constitute a predetermined circuit pattern.

The insulating layer 61 is constituted by an insulating material, such as ceramic or resin, containing aluminum oxide (Al₂O₃) , aluminum nitride (AlN), silicon nitride (Si₃N₄), or the like as a main component. The insulating layer 61 may be a resin substrate containing a combination of glass fibers and an epoxy resin, for example. The upper wiring layer and the lower wiring layer are constituted by conductor foil containing copper (Cu), aluminum (Al), or the like, for example.

As illustrated in FIG. 1, the printed circuit board 6 is provided with a plurality of through holes (via holes) 6x penetrating the insulating layer 61, the upper wiring layer, and the lower wiring layer. A plurality of pin terminals (post electrodes) 50 is inserted (press-fitted) into the plurality of through holes 6x of the printed circuit board 6 and fixed therein. The printed circuit board 6 and the pin terminals 50 constitute implant substrates (6, 50). A conductive layer (not illustrated) conducting the upper wiring layer and the lower wiring layer is formed on the inner surface of each of the through holes 6x. The conductive layers on the inner surfaces are conductive with the inserted pin terminals 50, so that the upper wiring layer and the lower wiring layer may have the same potential.

The pin terminals 50 may have a rod shape (pin shape) or a columnar shape, for example, and specifically may be a cylindrical column, an elliptical column, or a polygonal columnar, such as a triangular column or a square column. As a material of the pin terminals 50, a conductive material, such as copper (Cu), can be used. The pin terminals 50 include pin terminals 51, 52 illustrated in FIG. 1 and a pin terminal 53 illustrated in FIG. 2. As illustrated in FIG. 1, the lower end of the pin terminal 51 is joined to the upper conductor layer 12b via solder 9a. The pin terminal 51 is one example of the first pin terminal. As illustrated in FIG. 2, two or more of the pin terminals 51 are provided, and are, but not limited thereto, aligned in a row, for example. The pin terminals 51 are joined to the upper conductor layer 12b, which is the upper conductor layer to which the external terminal 4 is joined among the plurality of upper conductor layers. The number of the pin terminals 51 is not limited to the number illustrated in FIG. 2. As illustrated in FIG. 2, the lower ends of the pin terminals 52 are joined to a source electrode 31 of the semiconductor chip 3a via solder 9b. FIG. 2 illustrates the solder 2b, 9a before reflow (heat treatment). Although the number of the pin terminals 52 joined to the source electrode 31 is four, the number of the pin terminals 52 joined to the semiconductor chip 3a may be three or less or five or more.

As illustrated in FIG. 2, the lower end of the pin terminal 53 is joined to the gate electrode 32 of the semiconductor chip 3a via solder 9c. A drain electrode (not illustrated) on the lower surface side of the semiconductor chip 3a is joined to the upper conductor layer 12a illustrated in FIG. 1 via the solder 2a. The solder 9a, 9b, 9c is a joining material. As the solder, a tin-antimony (SnSb)-based solder or a tin-silver (SnAg)-based solder can be used, for example. The configurations of the semiconductor chips 3b, 3c, 3d are the same as that of the semiconductor chip 3a, and the configurations of the pin terminals 50 connected to the semiconductor chips 3b, 3c, 3d are also the same as that in the case of the semiconductor chip 3a, and therefore a description thereof is omitted. The pin terminals 50 may include pin terminals other than the pin terminals 51 to 53. For example, the pin terminals 50 may include a positioning pin terminal (not illustrated) used to fix the relative positional relation between the insulating circuit board 1 and the printed circuit board 6 or the like.

### <External terminal>

As illustrated in FIG. 1, the external terminal 4 is separated from the printed circuit board 6 and is not connected thereto. The pin terminals 50 are fixed in the through holes 6x of the printed circuit board 6, whereas the external terminal 4 is not fixed to the printed circuit board 6. The external terminal 4 has a joining part 41 which is a portion joined to the upper conductor layer 12b via the solder 2b, a connection part 42 which is a portion connected to an external circuit, and an intermediate part 43 which is a portion connecting the joining part 41 and the connection part 42. The joining part 41 extends in a direction parallel to the upper conductor layer 12b and has a lower surface joined to the upper conductor layer 12b via the solder 2b. The joining part 41 is provided with a boss 41a protruding (formed convexly) toward the upper conductor layer 12b. In reflow, the external terminal 4 is pressed toward the upper conductor layer 12b while being fixed by a jig. At this time, the boss 41a approaches the upper conductor layer 12b. A portion where the boss 41a is not provided of the joining part 41 cannot approach the upper conductor layer 12b as much as the boss 41a even when pressed. Thus, by providing the boss 41a, an excessive reduction in size of a space between the portion where the boss 41a is not provided of the joining part 41 and the upper conductor layer 12b is suppressed. This can suppress an excessive reduction in the amount of the solder 2b interposed between the joining part 41 and the upper conductor layer 12b. The solder 2b has a thickness of about 50 µm or more and 500 µm or less, for example, in the portion where the boss 41a is not provided of the joining part 41.

The connection part 42 is positioned above the joining part 41. The connection part 42 extends in a direction parallel to the joining part 41, and at least a part of the connection part 42 is exposed to the outside of the sealing member 8. An external circuit is connected to a portion exposed to the outside of the sealing member 8 of the connection part 42. An intermediate part 43 extends along a direction perpendicular to the upper conductor layer 12b, with one end along the perpendicular direction connected to the joining part 41 and the other end connected to the connection part 42. The joining part 41 to the connection part 42 may be formed continuously and integrally. The external terminal 4, the pin terminals 51, and the upper conductor layer 12b constitute the external terminal connection structures (4, 51, 12b).

For example, when the semiconductor device according to the first embodiment is a three-terminal inverter, the external terminal 4 may be any one of an anode-side (P-side) terminal, a cathode-side (N-side) terminal, and an output terminal. Further, the above-described external terminal connection structures (4, 51, 12b) may be provided in each or some of the anode-side (P-side) terminal, the cathode-side (N-side) terminal, and the output terminal, for example. When the semiconductor device according to the first embodiment is a four-terminal inverter, the above-described external terminal connection structures (4, 51, 12b) may be provided in an M-terminal. As a material of the external terminal 4, a conductive material, such as copper (Cu), can be used.

### <First joining region and Second joining region>

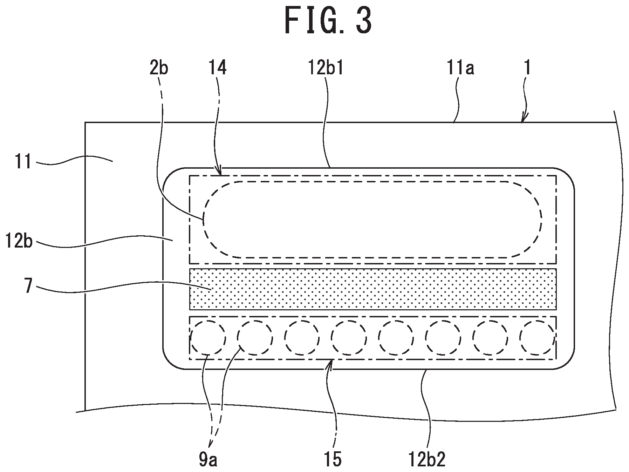

As illustrated in FIG. 2, the upper conductor layer 12b is provided in proximity to a first side 11a which is one side in plan view of the insulating substrate 11. The "proximity" means that no other upper conductor layers are provided between the upper conductor layer 12b and the first side 11a. The upper surface of the insulating substrate 11 is exposed around the upper conductor layer 12b and between the upper conductor layer 12b and the first side 11a. The upper conductor layer 12a is provided on the side opposite to the first side 11a with the upper conductor layer 12b interposed therebetween in the upper surface of the insulating substrate 11. The upper conductor layer 12a is adjacent to the upper conductor layer 12b with a space therebetween. FIG. 3 is a plan view illustrating the upper conductor layer 12b in an enlarged manner. The joining part 41 (not illustrated) of the external terminal 4 is joined to a first joining region 14 which is one region of the upper surface of the upper conductor layer 12b via the solder 2b. The lower ends of the pin terminals 51 (not illustrated) are joined to a second joining region 15 which is another one region of the upper surface of the upper conductor layer 12b via the solder 9a. When the side closer to the first side 11a among the sides in plan view of the upper conductor layer 12b is set as a second side 12b1 and the side opposite to the second side 12b1 among the sides is set as a third side 12b2, the first joining region 14 is the region closer to the second side 12b1 and the second joining region 15 is the region closer to the third side 12b2.

The first joining region 14 and the second joining region 15 are regions to which the external terminal 4 and the pin terminals 51 are expected to be connected. In FIG. 3, the first joining region 14 and the second joining region 15 are illustrated as rectangular regions using alternate long and short dash lines, but the shapes of the first joining region 14 and the second joining region 15 are not limited thereto. The first joining region 14 and the second joining region 15 are regions where the solder 2b, 9a is arranged, respectively. FIG. 3 illustrates the solder 2b, 9a before reflow. The solder 2b, 9a may wet-spread to the outside of the first joining region 14 and the second joining region 15 by reflow. The solder 9a provided in each pin terminal 51 may wet-spread to be connected to each other by reflow.

### <Solder resist>

As illustrated in FIG. 3, the solder resist 7 is provided on the upper surface side of the upper conductor layer 12b. More specifically, the solder resist 7 is provided at a position adjacent (in proximity) to the first joining region 14 of the upper surface of the upper conductor layer 12b. In this embodiment, the solder resist 7 is provided between the first joining region 14 and the second joining region 15. As illustrated in FIG. 2, the solder resist 7 extends along the X-direction. The dimension (longitudinal dimension) along the X-direction of the solder resist 7 may be equal to or larger than the width occupied by the joining part 41 of the external terminal 4 along the X-direction or may be equal to or larger than the width occupied by the lower end of the pin terminal 51 along the X-direction. The longitudinal dimension of the solder resist 7 may be equal to or larger than the larger width of the width occupied by the joining part 41 of the external terminal 4 along the X-direction and the width occupied by the lower ends of the plurality of pin terminals 51 along the X-direction, for example. When the plurality of pin terminals 51 is present, the width occupied by the lower end of the pin terminal 51 along the X-direction is the width occupied by the plurality of pin terminals 51 along the X-direction. The dimension along the Y-direction (lateral dimension) of the solder resist 7 may be determined according to a space between the joining part 41 of the external terminal 4 and the pin terminals 51. More specifically, the lateral dimension of the solder resist 7 may be determined according to a space between the first joining region 14 and the second joining region 15. To save space, the space between the joining part 41 of the external terminal 4 and the pin terminals 51 is desirably made as small as possible. The solder resist 7 is provided such that the lateral dimension is about 0.1 mm or more and 1 mm or less, for example. By providing the solder resist 7, the solder 2b and the solder 9a melted by reflow are less likely to be connected to each other.

### <Method for manufacturing solder resist>

Hereinafter, a method for manufacturing the solder resist 7 is described. As illustrated in FIG. 1, the solder resist 7 is a laser resist formed by irradiating the upper surface of the upper conductor layer 12b with laser light. Hereinafter, two examples of the wavelength, the output, and the frequency of a laser and the scanning conditions of the laser light are described below. The solder resist 7 is constituted by aligning a plurality of lines formed by laser irradiation in the longitudinal direction, for example.
Condition example 1
   Wavelength: 1064 (nm)
   Output: 5 (W)
   Frequency: 5 (kHz)
   Scanning speed: 8 (mm/s)
   Line pitch: 100 (µm)
Condition example 2
   Wavelength: 532 (nm)
   Output: 4.8 (W)
   Frequency: 30 (kHz)
   Scanning speed: 300 (mm/s)
   Line pitch: 10 (µm)

When laser light is emitted to the upper surface of the upper conductor layer 12b, irregularities are formed on the upper surface side of the upper conductor layer 12b, reducing the wettability of solder. Further, an oxide film is formed on the upper surface side of the upper conductor layer 12b, reducing the wettability of the solder.

### <Comparative Example>

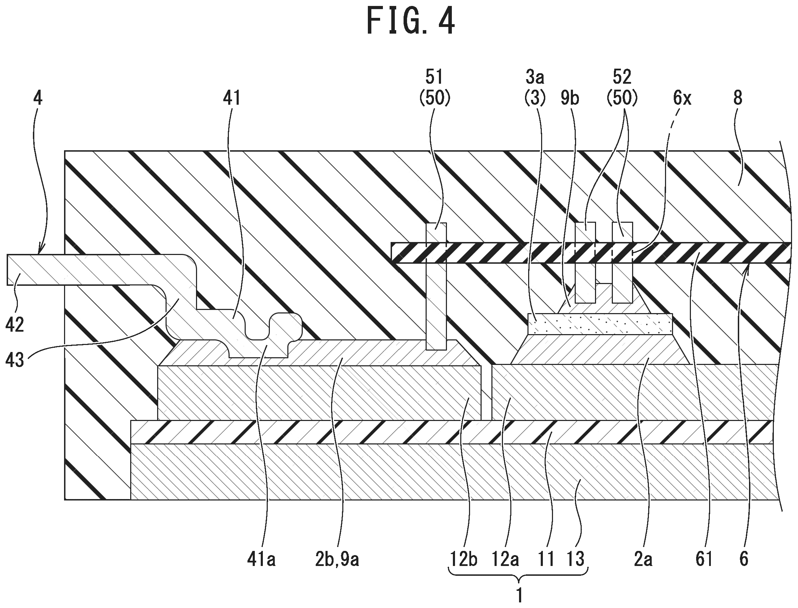

Hereinafter, a comparative example illustrated in FIG. 4 is described. In a semiconductor device according to the comparative example, the solder resist 7 is not formed on the upper surface side of the upper conductor layer 12b. When the solder resist 7 is not provided, there is a possibility that the solder 2b and the solder 9a melted by reflow wet-spread to be connected to each other. When the melted solder 2b and solder 9a are connected to each other, there is a possibility that the solder is attracted from one side to the other side of the external terminal 4 side and the pin terminal 51 side. For example, the solder is sometimes attracted and moves from the external terminal 4 side to the pin terminal 51 side. Then, when the solder is attracted and moves, there is a possibility that the solder is unevenly present on the external terminal 4 side and the pin terminal 51 side. Further, when the solder 2b, 9a wet-spreads, the solder 2b, 9a sometimes entirely decreases in thickness. When the solder 2b, 9a decreases in thickness, there is a possibility that the reliability of the solder joint and the joinability between the external terminal 4 and the pin terminals 51, and the upper conductor layer 12b decrease.

When electrical connection is made using wire bonding, the degree of freedom is high and the influence of the solder flow can be suppressed. However, the wire bonding requires a certain amount of wiring space.

In contrast thereto, the semiconductor device according to the first embodiment of the present technology has the solder resist 7 provided on the upper surface side of the upper conductor layer 12b and adjacent to the first joining region 14 as illustrated in FIG. 3. Since the wettability of the solder resist 7 is lower than that of the upper surface of the other upper conductor layer 12b, the solder 2b, 9a is prevented from excessively spreading, making the solder 2b, 9a less likely to be connected to each other (less likely to bridge). This can suppress an excessive reduction in film thickness of the solder 2b, 9a, can stabilize the fillet shape of the solder 2b, 9a, and can suppress a reduction in non-defective rate of the semiconductor device.

According to the semiconductor device of the first embodiment of the present technology, the solder resist 7 is provided between the first joining region 14 and the second joining region 15 as illustrated in FIG. 3. The solder 2b, 9a is less likely to move beyond the solder resist 7 and is less likely to be connected to each other. This can suppress an excessive reduction in film thickness of the solder 2b, 9a, can stabilize the fillet shape of the solder 2b, 9a, and can suppress a reduction in non-defective rate of the semiconductor device.

The semiconductor device according to the first embodiment of the present technology includes the printed circuit board 6 arranged above the semiconductor chip 3 and the pin terminals 51 inserted into the printed circuit board 6 and joined to the second joining region 15 which is another one region of the upper surface of the upper conductor layer 12b via the solder 9a. Therefore, wiring can be configured at a density higher than that when electrical connection is made using wire bonding.

According to the semiconductor device of the first embodiment of the present technology, the solder resist 7 is a laser resist, and therefore a step of forming the solder resist 7 can be easily performed.

### <First modification of first embodiment>

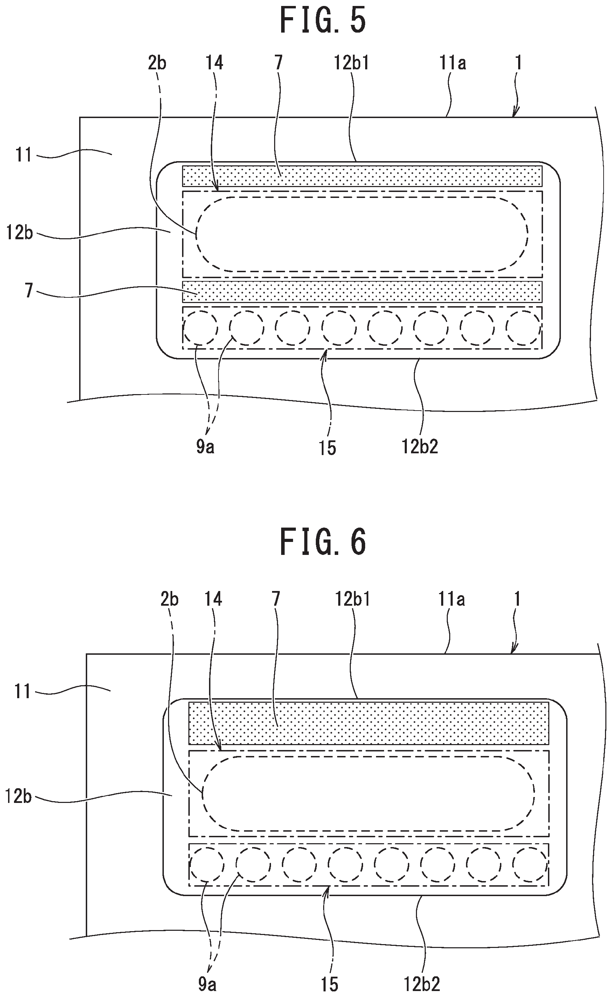

A semiconductor device according to a first modification of the first embodiment is different from the semiconductor device according to the first embodiment illustrated in FIG. 1 in that the solder resist 7 is provided both between the first joining region 14 and the second joining region 15 and between the first joining region 14 and the second side 12b1 as illustrated in FIG. 5. The other configurations of the semiconductor device according to the first modification of the first embodiment are the same as those of the semiconductor device according to the first embodiment, and therefore redundant descriptions are omitted.

As illustrated in FIG. 1, the external terminal 4 connected to an external circuit is required to be provided near an end part (first side 11a) of the insulating circuit board 1 (insulating substrate 11) in plan view. The lower conductor layer 13 overlaps the entire lower surface of the insulating substrate 11. The area in plan view of the lower conductor layer 13 is the same as that of the insulating substrate 11, and the lower conductor layer 13 is provided to cover the entire lower surface of the insulating substrate 11. An end part 13a of the lower conductor layer 13 overlaps the first side 11a in plan view of the insulating substrate 11. The upper conductor layer 12b is not provided up to the first side 11a, and, as illustrated in FIG. 2, the upper surface of the insulating substrate 11 is exposed between the first side 11a and the second side 12b1. By exposing the upper surface of the insulating substrate 11 between the first side 11a and the second side 12b1, the distance between the lower conductor layer 13 and the upper conductor layer 12b is increased, securing the insulation properties.

There is a possibility that the solder 2b melted in reflow wet-spreads onto the insulating substrate 11 exposed between the first side 11a and the second side 12b1. When the solder 2b wet-spreads onto the insulating substrate 11, the distance for securing the insulation properties between the lower conductor layer 13 and the upper conductor layer 12b decreases.

In contrast thereto, the semiconductor device according to the modification 1 of the first embodiment of the present technology is provided with the solder resist 7 between the first joining region 14 and the second side 12b1, and therefore the wet-spreading of the solder 2b onto the insulating substrate 11 can be suppressed and a reduction in insulation properties between the lower conductor layer 13 and the upper conductor layer 12b can be suppressed. Further, even the semiconductor device according to the first modification of the first embodiment has the same effects as those of the semiconductor device according to the first embodiment.

### <Second modification of first embodiment>

A semiconductor device according to a second modification of the first embodiment is different from the semiconductor device according to the first modification of the first embodiment illustrated in FIG. 5 in that the solder resist 7 is provided only between the first joining region 14 and the second side 12b1 as illustrated in FIG. 6. The other configurations of the semiconductor device according to the second modification of the first embodiment are the same as those of the first modification of the semiconductor device according to the first embodiment, and therefore redundant descriptions are omitted.

### (Other embodiments)

As described above, although the present invention is described by the first embodiment and the modifications thereof, the discussion and the drawings forming a part of this disclosure should not be understood as limiting the present invention. Various alternative embodiments, examples, and operation technologies will be apparent to those skilled in the art from this disclosure.

For example, the configurations disclosed in the first embodiment and the modifications thereof can be appropriately combined without contradictions. As described above, it is a matter of course that the present invention includes various embodiments and the like not described herein. Therefore, the technical scope of the present invention is defined only by the matters specifying the invention according to each reasonable claim from the description above.

### Reference Signs List

3, 3a, 3b, 3c, 3d: semiconductor chip
6: printed circuit board
7: solder resist
1: insulating circuit board
11: insulating substrate
11a: first side
12a: upper conductor layer (first conductor layer)
12b: upper conductor layer (second conductor layer)
12b1: second side
12b2: third side
13: lower conductor layer
13a: end part
14: first joining region
15: second joining region
4: external terminal
41: joining part
41a: boss
50, 52, 53: pin terminal
51: pin terminal (first pin terminal)

## Claims

1. A semiconductor device comprising:
an insulating circuit board having an insulating substrate and a first conductor layer and a second conductor layer provided separately from each other on an upper surface of the insulating substrate;
a semiconductor chip mounted on the first conductor layer via solder;
an external terminal having a joining part, the joining part being joined to a first joining region via solder, the first joining region being one region of an upper surface of the second conductor layer;
a printed circuit board arranged above the semiconductor chip;
a first pin terminal inserted into the printed circuit board and joined to a second joining region via solder, the second joining region being another one region of the upper surface of the second conductor layer; and
a solder resist provided on an upper surface side of the second conductor layer and adjacent to the first joining region.

2. The semiconductor device according to claim 1, wherein
the second conductor layer is provided in proximity to a first side, the first side being one side of the insulating substrate, and
when a side closer to the first side among sides of the second conductor layer is set as a second side and a side opposite to the second side among the sides is set as a third side, the first joining region is the region closer to the second side and the second joining region is the region closer to the third side.

3. The semiconductor device according to claim 1 or 2, wherein
the solder resist is provided between the first joining region and the second joining region.

4. The semiconductor device according to claim 2, wherein
the solder resist is provided between the first joining region and the second side.

5. The semiconductor device according to claim 1 or 2, wherein
the external terminal is separated from the printed circuit board.

6. The semiconductor device according to claim 1 or 2, wherein
the joining part is provided with a boss protruding toward the second conductor layer.

7. The semiconductor device according to claim 6, wherein
the solder interposed between the joining part and the second conductor layer has a thickness of 50 µm or more and 500 µm or less in a portion where the boss is not provided of the joining part.

8. The semiconductor device according to claim 1 or 2, wherein
the insulating substrate contains a resin material.

9. The semiconductor device according to claim 1 or 2, wherein
copper is exposed to surfaces of the first conductor layer and the second conductor layer.

10. The semiconductor device according to claim 1 or 2, wherein
the solder resist is a laser resist provided by irradiating the upper surface of the second conductor layer with laser light.
